# EUROPEAN PATENT APPLICATION

(11) **EP 0 789 391 A2**
(43) Date of publication of application: **13.08.1997**
(21) Application number: 97300788.3
(22) Date of filing: 07.02.1997
(51) Int. Cl.: H01L 21/60, H01L 21/00, B23K 3/06

(54) **Method and apparatus for application of flux, paste, or adhesive to bump array interconnections**

(30) Priority: 08.02.1996 US 598259
(71) Applicant: ZEVATECH, INCORPORATED, Morrisville, NC 27560 (US)
(72) Inventor: Hudson, Edison T., Chapel Hill, NC 27516 (US)
(74) Representative: Leeming, John Gerard

(57) **Abstract**

A combination of a device for producing a closed deck type cylinder block and a sand core to be used in the device, the combination being capable of producing the block having high dimensional accuracy and eliminating precise dimensional control to the end face portion of the sand core. The sand core has a configuration identical with a water jacket formed in the engine block. Holding projections extending in an axial direction of a cylinder liner integrally protrude from a slide core of a movable die, and complementary holding bores are formed in the sand core, the bores being open at a top deck end face of the sand core. In one preferred embodiment, the top deck end face of the sand core is of a planner arrangement, and an end face of the slide core is formed with recesses for forming bridge portions therein. Casting is performed while maintaining a surface contact between the planr.er end face and the end face of the slide core. The contacting areas will become windows of the water jacket.

## Description

This invention is directed generally to the field of attaching electrical components to circuit boards and the like. More specifically, this invention is directed to a method and apparatus for applying a precision coating of a desired flux material, paste material or adhesive to bump-type array interconnections (such as, for example, "flip chip", "C4" or "ball grid array" type interconnection systems) of such components as a step in the attachment of such components or component packages to a circuit board or like carrier. Such systems are often referred to in the art as "chip fluxers" because they are commonly used to deliver solder flux to solder bumps or balls which are to be reflowed. Herein, the term "flux" will sometimes be used to collectively refer to flux material, paste material, adhesive material and other similar types of materials of various viscosities to be applied with a "chip fluxer" or like machine.

Many semiconductor die and surface mount electronic components are beginning to use "flip-chip", "C4" or "ball grid array" technology as a means of building low cost, high performance, high input/output density assemblies. In these types of assemblies, metal bumps, studs, or balls of metals (collectively referred to herein as "bump-type" interconnections) are usually applied in a two dimensional array pattern, either directly to the active surface of a semiconductor chip, or alternatively, to an intermediate substrate carrier of the semiconductor. The assembly is made by flipping the active, bumped surface over and then aligning the bumps of the chip with corresponding pads on a substrate to which the electrical connection is to be made. The substrate may be either a part of a semiconductor package (such as a multi-chip module, ceramic chip carrier, or the like), or a board level assembly. The metal bumps are commonly fabricated of a solder composition that can be mass reflowed in an oven, at which point all of the contacts of all of the bumps are soldered simultaneously (see, for example, U.S. Patent No. 5,075,965 to Carrey et al., entitled "Low Temperature Controlled Collapse Chip Attach Process" which generally describes the "flip chip", "C4" or "ball grid array" technology). In another variant of the flip-chip method, metal studs or "stud bumps" are attached to the chip by a wire-bond method, and the assembly is made by application of an electrically conductive adhesive material, which is subsequently cured *en masse* in an oven. There is also a flip chip assembly method that uses thermo-compression as a method of joining mating gold or aluminum bumps.

As a critical step in the flip chip process, an activation material such as solder flux must be applied to each bump. It is desirable to minimize the amount of flux used in solder methods, because the fluxing agents are often chemically active, and therefore any excess must be removed prior to final use or else corrosion of contacts may ensue. To eliminate or reduce the post assembly flux cleaning process, it is very desirable to apply the minimum amounts of flux, preferably applying only a small "halo" of flux to each bump. Since typical flip chip assemblies may have over 100 bumps (up to or exceeding 3000 bumps in some cases), a gang method of application of flux to bumps is needed. Similarly, where conductive adhesive or paste is needed, a similar application system is needed.

In the case of conductive adhesive methods of assembly, it is also important to apply conductive material only to the bumps. Some methods of adhesive attach use an area approach. In such an approach the entire surface underneath the chip is coated with the adhesive material, with the compression of the bump areas only being activated into electrical conductivity by pressure. Such an approach is wasteful of expensive metal filled adhesives and increases the possibility of undesired parasitics and losses at high frequency.

For coarse dimensioned ball array components, the use of screen printing to the substrate is also used. This method is generally considered unreliable for balls below about 300 microns in diameter due to well known alignment and smearing problems associated with screen printing. Many semiconductor devices have bumps as small as 50 microns, and so these approaches are not practical for use with such chips. Methods such as spraying and area printing of materials have been used, but these have proven costly and are prone to poor yields.

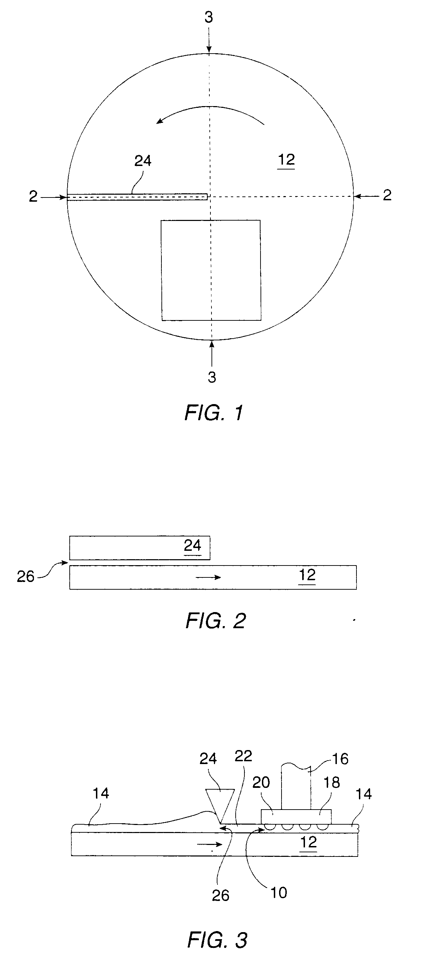

Zevatech, Inc. of Morrisville, North Carolina has developed a method using the principal of print transfer to apply flux and other materials to bumped assemblies that are currently in widespread use with a product known as the "Zevatech Micron 2 Plate Fluxer". This method, depicted in FIGS. 1 - 3, involves stamping the bump arrays 10 on a very flat plate 12 that has been coated by a thin film coating 14 of the flux or other viscous material. The stamping is performed by a conventional pick and place assembly robot such as a Zevatech Micron 2 (not shown) using a vacuum nozzle 16 or collet to grip the back-side (non-bumped side) 18, of the component 20. A thin film coating 22 is applied to the plate 12 as it rotates circularly in its own plane under a "doctor" blade 24, which is disposed above a fixed gap 26 over the rotating plate 12. Other companies (KME and Panasonic in Japan, Universal Instruments in USA, possibly others) have developed similar "flat printing plate" systems.

In the flat printing plate systems the printing plate 12 moves in a circle until just before the print transfer process. Before the printing can occur, the plate 12 must be completely stopped in order to prevent smearing or build-up of the printed material on one side of the bumps 10. The printing motion is down then up, orthogonal to the rotating plate 12.

While fit for its intended use, two major inefficiencies inherent in such flat printing plate systems are: 1) the rotating transfer plate and the component must be stopped during the printing step; and 2) removal of the printed component from the plate must be performed slowly in order to prevent the hold of the component by the placement machine (usually via a vacuum nozzle) from being overcome by the adhesion of the component to the surface of the transfer plate. In short, the plate transfer method introduces certain inescapable processing delays into the system. For example, the delay introduced to allow an automatic pick and place machine to perform this operation may typically be 1 second out of an entire placement cycle of 3 seconds (33% of the cycle). Furthermore, very small components often cannot be processed using this method because the adhesion of the component to the surface is greater than the vacuum force holding the back side of the component on the pick and place machine nozzle.

In summary, in the "flip-chip" and bump array assembly systems, it is highly desirable to introduce an efficient, fast and practical method of applying materials such as fluxes, pastes and adhesives to each individual bump of a two dimensional array of bumps. Such an approach will reduce material usage, manufacturing time, post assembly cleaning, and adverse side effects on the reliability, life, and performance of the assembly.

The present invention overcomes the limitations of the prior art by providing an "on-the-fly" printing method for applying a viscous material such as a flux, paste, adhesive or other desired material to the bumps of a bump-type chip or carrier (hereinafter "component"). In essence the invention is an apparatus and method comprising coating the outer surface of a rotating drum with a film of the desired material, fixing the thickness of the film of material precisely with a doctor blade, and passing the bump-type component across the top of the drum at a speed in synchronicity with the linear speed of the top of the drum so as to imprint the desired material on the bumps of the component without any smearing and without the need to stop the drum or slowly pull the component away from engagement with the drum. This invention results in a significant speed increase over the prior art flat plate printing method.

Accordingly, it is an aim of the present invention to provide an improved method and apparatus for applying a flux, paste or adhesive material to bumps of a bump-type component.

It is a further aim of the present invention to provide an improved apparatus for transferring material to bumps of a bump-type component.

It is a further aim of the present invention to provide a faster apparatus for transferring predetermined amounts of a flux-like material to bumps of a bump-type component.

Yet a further aim of the present invention is to provide a faster method for transferring predetermined amounts of a flux-like material to bumps of a bump-type component.

These and other aims and advantages of the present invention will become apparent to those of ordinary skill in the art from a consideration of the drawings and ensuing description of an exemplary embodiment of the invention.

In the drawings :

FIG. 1 is a schematic diagram of a prior art chip fluxer.

FIG. 2 is a cross sectional drawing taken along line 2-2 of FIG 1.

FIG. 3 is a cross sectional drawing taken along line 3-3 of FIG 1.

FIG. 4 is a side cross sectional view of a chip fluxer according to a presently preferred embodiment of the present invention.

FIG. 5 is a top plan view of a chip fluxer according to a presently preferred embodiment of the present invention.

Those of ordinary skill in the art will realize that the following description of the present invention is illustrative only and is not intended to be in any way limiting. Other embodiments of the invention will readily suggest themselves to such skilled persons from an examination of the disclosure.

The present invention provides improved efficiency over the prior art flat plate print transfer method shown in FIGS. 1 - 3 by allowing the application of the flux material to the bumps of the component while the component is in continuous motion. This "on-the-fly" approach avoids the delays associated with the flat plate printing method which requires that the component be halted in its horizontal travel during its vertical travel to and from the flat printing plate. The approach of the present invention has the following benefits:
1) By using tight synchronization of the surface velocity of the outer surface of a rotating drum with the linear velocity of the moving assembly robot, transfer of material to the bumps can be performed "on-the-fly" with minimal impact to the assembly cycle time;
2) By contacting only a small cross section of the component at once (usually only one row of the two dimensional bump array) the adhesive forces applied to the component are minimized and permit smaller components to be assembled using this invention;
3) The reduction of forces provided by this invention, and consequently the reduction of potential for disturbance of the component on the robot nozzle, make possible the use of optical alignment techniques prior to the application of flux to the component. This attribute is very desirable because it allows the component to be examined and measured by machine vision in a pristine state, prior to application of the flux to the bumps. This will result in higher accuracy placement of the component and permit higher bump densities to be used;
4) In a variant of this invention, the use of soak pockets in the rotating drum outer surface along with regular rotational speed control of the drum by means of encoding the drum rotation, permit the use of low viscosity flux-like materials as well as more viscous liquids.

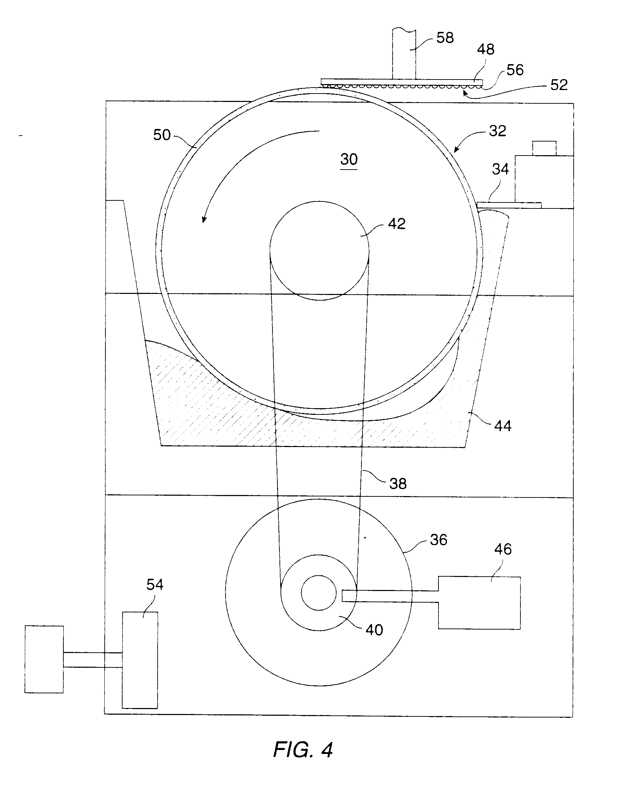

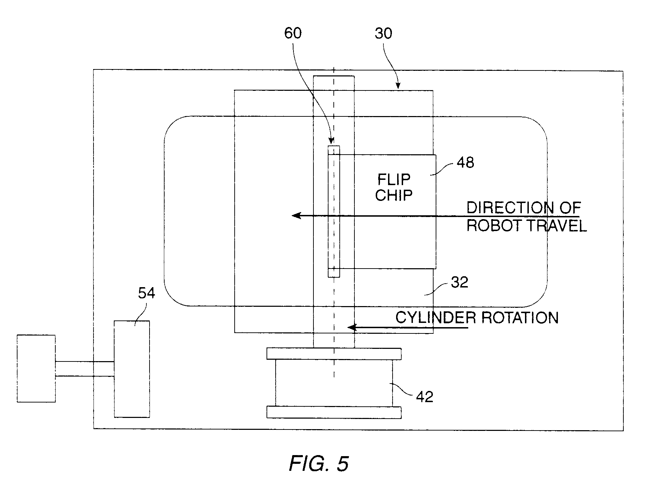

According to a presently preferred embodiment of the present invention, the apparatus for applying material to the component bumps is shown in FIGS. 4 and 5 and comprises a smooth rotating cylindrical drum 30 having an outer surface 32, a leveling "doctor" blade 34, a motor 36 to drive rotation of the cylinder via a drive belt 38 and a pair of pulleys 40, 42, a reservoir 44 for the liquid material to be applied, and a shaft encoder 46 or other mechanism for providing velocity feedback so that the speed of the component 48 across the top of the rotating drum 30 can be synchronized with the speed of the outer surface 32 of the drum 30.

The smooth rotating cylindrical drum 30 must have a smooth outer surface 32 in order to present a uniform thickness of material 50 deposited on outer surface 32. The smoothness requirement of the surface relates to the minimum thickness of material that may be applied. For semiconductor devices, bumps are often no taller than 25 microns. This will usually require a cylinder surface with no deviations more than about 5 microns from an ideal cylinder. For coarser ball array assemblies with ball heights of over 500 microns, the smoothness of the cylinder surface need not be better than about 100 microns.

The leveling "doctor" blade 34 is suspended above drum 30 at a height equal to the thickness of the film 50 of material to be coated on drum 30. This blade must be straight and flat, and typically is like a razor at its edge.

The motor 36 to drive rotation of the drum 30 will in most cases be set up to drive the cylinder in continuous rotation about its longitudinal axis (i.e., about an axis horizontal to the ground). While this is not required for use of the invention, it will generally prove the most practical arrangement in order to maintain a uniform film thickness at all points on the outer surface 32 where the component 48 contacts the film 50 to "print" or apply material from reservoir 44 to the bumps 52 of component 48. In some cases, such as the use of low viscosity materials deposited in depressions or pockets of the cylinder, the motion must be stopped temporarily. To allow for the use of a wide range of material viscosity, it is required that the motor drive be driven by a power source with variable speed control. In FIG. 4 the variable speed control is shown as a manual adjustable control 54, however, an electronic control under the control of a computer could also be used, as desired, and such controls are well understood by those of ordinary skill in the art.

The reservoir 44 for material to be applied brings the material to be applied in contact with the bottom side of rotating drum 30 so that a continuous supply is maintained to the doctor blade 34. In the case of low viscosity materials, the reservoir may act like a waterfall to dump material onto the rotating cylinder immediately adjacent to the contact area (here shown at the 12 O'clock position of the drum 30). The rotating drum 30 returns excess material to the reservoir for re-use. The reservoir 44 may be attached to an external control system which maintains density of the material at a prescribed level.

In use, the component 48 having a bump array 52 on its lower side 56 is picked up by a pick and place robot such as a Zevatech Micron 2 (not shown) with a vacuum nozzle or collet 58 in a conventional manner well known to those of ordinary skill in the art. The component is then driven over the drum 30 so that bump array 52 makes contact with film 50 to print the material from reservoir 44 onto bump array 52. Critical to this step is that the speed of the outer surface 32 of drum 30 and the speed of component 48 be virtually the same while in contact to avoid smearing or buildup of material about the bumps of bump array 52. The two speeds which must be equated are the linear speed of the outer surface 32 at the line of contact (60 in FIG. 5) with component 48 and the linear speed of the component 48 caused by motion of the pick and place robot. A number of well known mechanisms can be used to equate these two speeds. Preferably the robot speed is controlled as a function of a relatively constant and monitored rotational speed of drum 30. In a presently preferred embodiment of the present invention, the drum rotational speed is determined with a shaft encoder linked to the motor drive 36. Obviously, speed detection can be done at a number of points in the systems, e.g., pulley, motor, drive belt, etc. and in a number of different conventional manners. There is no requirement that a drive belt be used to drive the drum 30. Instead, a direct drive motor could be used if preferred. There is no requirement that the robot speed be slaved to the rotation rate of the drum 30. The drum rotation rate could be slaved to the robot speed or both could be mutually controlled. It is presently preferred to slave the robot speed to the rotational rate of the drum because it has been found to be a simpler procedure with the presently preferred embodiment and it is generally easier to adjust the linear speed of the robot than it is to adjust the rotational speed of the drum 30 given the relative inertia of the two parts. In practice, according to a presently preferred embodiment of the present invention, the linear surface velocity of the rotating cylinder is exactly (or closely) matched by the linear motion of the assembly robot or machine by using the shaft encoder attached either to the cylinder's axis of rotation or the motor to provide feedback of instantaneous velocity and position. The feedback is integrated with the trajectory of the assembly robot or machine so that the forward velocity of the cylinder at the line of contact 60 and the linear translation of the robot are exactly matched.

Operation of the present invention takes place as follows.
1) Liquid material to be applied to the bumps is loaded into reservoir.
2) The doctor blade is adjusted and set to the thickness desired for the type of component and the material to be applied.
3) The cylinder is set in motion using the motor drive. For maximum throughput, the rotation rate of the cylinder may be set to the maximum allowable velocity that can be sustained without throwing off material from the cylinder surface. This is set with motor velocity control 54. The encoding device begins to send feedback on the velocity to the motion controller of the robot or machine which, in turn, uses the information to adjust the speed of the robot to match the speed of the drum 30.
4) The robot or assembly machine picks up a component to which material is to be applied and moves with it above the cylinder. The direction of motion of the component must be orthogonal to the axis of rotation of the cylinder, in the same direction as the rotation of the cylinder, and at a predetermined height above the cylinder so that only the desired depth of the bumps 52 on the component 48 are immersed in the film 50 of material adhering to the drum 30. The line of contact 60 for the component with the material adhering to the cylinder would preferably be the uppermost part of the cylinder which is rotating in a horizontal plane.
   The height (at line of contact) of the drum is determined by a calibration procedure, or by design, and is a critical parameter required for this method to be effective. This calibration may be determined by several methods including: A) use of a precision contact probe on the robot nozzle, or an electrical signal that is activated by the contact of the robot's nozzle with the conductive surface of the cylinder B) use of a precision component, mounted in a suitable precision fixture to arrive at a predetermined height for the top of the cylinder surface.
5) Prior to contact with the material on the surface, the robot must alter its forward velocity to precisely match the surface velocity of the rotating cylinder, so that at the moment of contact between the bumps 52 and the film 50, the component and drum are effectively at a near zero velocity relative to one another. Alternatively, using a servo control motor for the rotating cylinder, the cylinder rotation may be required to precisely match the forward velocity of the robot. Either robot path of the cylinder's speed of rotation must be slaved to the other. From a practical view, due to the need to set the best speed of the cylinder based on the material's viscosity, it will be more reliable, and a simplified system to have the robot's forward velocity slaved to the speed of the cylinder. It is the slaving of velocity that makes possible the continuous motion of the system and conveys the efficiencies of throughput to this method.
6) In the case of low viscosity materials, this approach must be used in a different mode, in which the cylinder comes to a stop at the top of rotation at which point a pocket or depression is presented. In this variation, the slaving of velocity and position of the pockets filled with material is important.

While illustrative embodiments and applications of this invention have been shown and described, it would be apparent to those skilled in the art that many more modifications than have been mentioned above are possible without departing from the inventive concepts set forth herein. The invention, therefore, is not to be limited except in the scope of the appended claims.

## Claims

1. A method of applying a material to the bumps of a bump-type component comprising the steps of:
rotating a drum;
applying the material to an outer surface of said rotating drum to form a film of the material on said outer surface, said film having a thickness;
controlling said thickness so that it is of a predetermined thickness at at least a line of contact on said outer surface of said rotating drum;
picking up the component to be imprinted with the material;
moving the component at a first speed tangentially to said outer surface of said rotating drum so that the bumps of the component contact the material at said line of contact causing material to be transferred to the bumps of the component from said outer surface of said rotating drum; and
controlling a second speed of said outer surface of said rotating drum at said line of contact and said first speed so as to minimize any difference between said first speed and said second speed while the bumps of the component are in contact with the material on said outer surface of said drum.

2. A method according to claim 1 wherein the step of rotating a drum comprises rotation about a horizontal axis.

3. A method according to claim 1 or 2, wherein the step of controlling the thickness is accomplished at least in part with a doctor blade.

4. A method according to claim 1, 2 or 3, wherein the step of picking up the component is accomplished at least in part with a pick and place robot.

5. A method according to claim 4 wherein the step of moving the component is accomplished at least in part with said pick and place robot.

6. An apparatus for applying a material to the bumps of a bump-type component, said apparatus comprising:
a drum;
means for rotating said drum about an axis of rotation at a rotational speed;
means for applying a layer of the material to an outer surface of said drum;
means for controlling the thickness of said layer at least a line of contact on said outer surface of said drum;
means for determining a parameter related to said rotational speed;
means for picking up and transporting the component at a linear speed in the vicinity of said line of contact so that the bumps of the component contact said outer surface of said drum at said line of contact causing transfer of the material to the bumps of the component; and
means for controlling said linear speed so that any relative motion between the component and said outer surface of said drum at said line of contact is minimized during transfer of the material to the bumps of the component.

7. An apparatus according to claim 6, wherein the means for controlling the thickness comprises a doctor blade.

8. An apparatus according to claim 6 or 7, wherein the means for determining a parameter related to said rotational speed comprises an encoder.

9. An apparatus according to claim 6, 7 or 8, wherein the means for picking up and transporting the component comprises a pick and place machine.

10. A method of manufacturing a circuit board including the steps of the method of any one of claims 1 to 5.
